Europäisches Patentamt

European Patent Office

Office européen des brevets

(11) Veröffentlichungsnummer: **0 380 767**
**A2**

(12) **EUROPÄISCHE PATENTANMELDUNG**

(21) Anmeldenummer: 89120528.8

(22) Anmeldetag: 06.11.89

(51) Int. Cl.⁵: **C08J 7/12, C23C 18/20**

(30) Priorität: 30.01.89 DE 3902991

(43) Veröffentlichungstag der Anmeldung:
08.08.90 Patentblatt 90/32

(84) Benannte Vertragsstaaten:
**BE CH DE ES FR GB IT LI LU NL SE**

(71) Anmelder: **SCHERING AKTIENGESELLSCHAFT**
**Müllerstrasse 170/78**
**D-1000 Berlin 65(DE)**

(72) Erfinder: **Römer, Michael, Dr.**
**Popitzweg 7**
**D-1000 Berlin 13(DE)**

(54) Verfahren zur haftfesten Metallisierung von hochtemperaturstabilen Kunststoffen.

(57) Die Erfindung betrifft ein Verfahren zur Vorbehandlung von Kunststoffen, insbesondere von Polyethersulfonen, für die haftfeste chemische Metallisierung, dadurch gekennzeichnet, daß die Kunststoffe mit einer quartären Base gelöst in einem organischen Lösungsmittel behandelt werden.

EP 0 380 767 A2

# VERFAHREN ZUR HAFTFESTEN METALLISIERUNG VON HOCHTEMPERATURSTABILEN KUNSTSTOFFEN

Die Erfindung betrifft ein Verfahren zur Vorbehandlung von Kunststoffen, insbesondere von Polyethersulfonen, für die haftfeste chemische Metallisierung. Unter Polyethersulfon sind alle Kunststoffe oder technischen Produkte zu verstehen, die $SO_2$-, Ether- und Phenylengruppen enthalten.

Unter Vorbehandlung wird die Vorbereitung oder Veränderung der Kunststoffoberflächen einschließlich der Füllstoffe (zum Beispiel Glasfaser) verstanden, mit dem Ziel die Aktivierung (Bekeimung durch (Edel)-Metalle oder Kohlenstoff vollständig und gleichmäßig zu gewährleisten und damit die chemische Metallisierung positiv zu beeinflussen.

Die Vorbehandlung von Kunststoffen auf Basis von Polyestern, Polyamiden, Polysulfonen, Polyurethanen unter anderem für die chemische Metallisierung ist bereits bekannt. Hierzu gehören zum Beispiel die Behandlung mittels alkalischer Reiniger, mittels $SO_3$, in der Gasphase, mittels netzmittelhaltiger Lösungsmittels oder mittels wasserlöslicher organischer Lösungsvermittler, die Hydroxylionen solvatisieren.

Für die Vorbehandlung von Kunststoffen auf Basis von Polyethersulfonen sind diese Behandlungsverfahren jedoch ungeeignet, da sie nur eine unbefriedigende Haftfestigkeit der abgeschiedenen Metallschichten bewirken.

Aufgabe der vorliegenden Erfindung ist die zur Verfügungsstellung eines Vorbehandlungsverfahrens für Kunststoffe der oben genannten Art, welches eine haftfeste chemische Metallisierung ermöglicht.

Diese Aufgabe wird gelöst durch ein Verfahren gemäß dem kennzeichnenden Merkmal des Patentanspruchs.

Vorteilhafte Ausführungsformen sind in den Unteransprüchen beschrieben.

Das erfindungsgemäße Verfahren ermöglicht vorteilhafter Weise eine haftfeste Metallisierung von Kunststoffoberflächen.

So werden die Kunststoffe überraschenderweise stark hydrophilisiert und damit in besonderer Weise für die Aktivierung vorbereitet, wobei gleichzeitig die Oberflächen aufquellen und der Angriff des Ätzmediums erleichtert und somit verstärkt wird.

Als Polyethersulfon wird ein thermoplastisches aromatisches Ethergruppen enthaltendes Polysulfon verstanden, welches periodische wiederkehrend $SO_2$-Gruppen und aromatische und/oder aromatische Bisphenol-A-Gruppen in der Kette enthält. Diese Produkte sind auf dem Markt als Polysulfone, Polyarylen (oder Polyphenylen)sulfone und Polyethersulfone bekannt. Diese Kunststoffe können gewünschtenfalls einen Glasfaseranteil oder Mineralanteil oder Mischungen von beiden enthalten.

Als erfindungsgemäß zu verwendende quartäre Basen sind insbesondere zu nennen:
Ammoniumhydroxid
Alkylammoniumhydroxid
Arylammoniumhydroxid
Vinyltriarylphosphoniumhydroxid
Tetraphenylphosphoniumhydroxid und
Tetraphenylarsoniumhydroxid

Eine herausragende Wirkung entfaltet weiterhin das Tetramethylammoniumhydroxid.

Geeignete Verbindungen sind außerdem die folgenden Basen beziehungsweise deren Salze, die gemeinsam mit Hydroxylionen verwendet werden:
Alkylbenzyldimethylammonium chlorid
(-)-N-Benzylquininium chlorid
Benzyltributylammonium bromid
Benzyltributylammonium chlorid
Benzyltriethylammonium chlorid
Benzyltriethylammonium hydroxid
Benzyltrimethylammonium chlorid
Benzyltrimethylammonium hydroxid
Benzyltrimethylammonium hydroxid
Butyltriphenylphosphonium chlorid
(-)-N-Dodecyl-N-methylephedrinium bromid
Ethylhexadecyldimethylammonium bromid
Ethyltrioctylphosphonium bromid
Hexadecyltrimethylammonium bromid
Hexadecyltrimethylammonium chlorid
Methyltrioctylammonium chlorid
Tetrabutylammonium fluorid trihydrat
Tetrabutylammonium hydrogen sulfat
Tetrabutylammonium hydroxid
Tetrabutylammoniumhydroxid
Tetrabutylammonium iodid
Tetrabutylammonium tetrafluoroborat
Tetrabutylphosphonium bromid
Tetrabutylphosphonium chlorid
Tetraethylammonium bromid
Tetraethylammonium chlorid
Tetraethylammonium cyanid
Tetraethylammonium hydroxid
Tetraethylammonium fluoroborat
Tetraoctylammonium bromid
Tetraphenylphosphonium bromid
Tetraphenylphosphonium chlorid
Tetrapropylammonium bromid
Tributylhexadecylphosphonium bromid
Tributylmethylammonium chlorid
Tetrapentylammonium bromid
Tetramethylammonium hydroxid
Tetrapropylammonium hydroxid (wässrige Lösung)
Tetrahexylammonium bromid

Tetradecyltrimethylammonium bromid
Methyltridecylammonium chlorid

Die Anwendung dieser Verbindungen erfolgt in Konzentrationen von 0,05 bis 200 g/Liter.

Es versteht sich, daß die erfindungsgemäßen Vorbehandlungsmittel als solche in originärer Form oder - falls gewünscht - in Form ihrer Salze in Gegenwart von Hydroxylionen verwendet werden können, aus denen die quartären Basen in Gegenwart von Hydroxylionen freigesetzt werden.

Als organische Lösungsmittel beziehungsweise lösungsvermittelnde Medien sind beispielsweise die folgenden zu nennen.

N-Methyl formamid
N-Methyl acetamid
Propylencarbonat
Ethylencarbonat
Acetonitril
Dimethylsulfoxid
N,N-Dimethylformamid
Dimethylacetamid
N-Methyl pyrrolidon
Methylenchlorid
Essigsäureethylester
1,4-Dioxan
Diethylcarbonat
γ-Butyrolacton
Ethylenglycol
Ethylenglycolmonomethylether
Ethylenglykolmonoethylether
Ethylenglycolmonobutylether
Ethylengylcolmonoisopropylether
Ethylenglycolmonoisobutylether
Ethylenglycolmono-tert-butylether
Ethylenglycolmono-n-hexylether
Ethylenglycolmono(2-aminoethyl)-ether
Ethylenglycoldiglycidylether
Ethylenglycolmonophenylether
Ethylenglycolmonoacetat
Ethylenglycoldiacetat
Ethylenglycolmonoethylether-acetat
Ethylenglycolmonoallylether
Ethylenglycoldimethylether
Ethylenglycolmonobutylether-acetat
Ethylenglycolmonobenzylether
Ethylenglycolmonoisoamylether
Methanol
Ethanol
n-Propanol
i-Propanol
n-Butanol
Glycerin
Glycerinaldehyd
Glyceringlycid
Glycerinmonomethylether
Glycerinmonoethylether
Diethylenglycol
Diethylenglycolmonomethylether

Diethylenglycolmonoethylether
Diethylenglycolmonobutylether
Diethylenglycoldiethylether
Diethylenglycoldimethylether
Triethylenglycol
Triethylenglycolmonoethylether
Triethylenglycolmonomethylether

Die Lösungsmittel werden zweckmäßigerweise in Anwendungskonzentrationen von 10 bis 100 Gewichtsprozent verwendet.

Gewünschtenfalls kann eine Mischung dieser Lösungsmittel mit Wasser oder niedrigen Alkoholen erfolgen.

Die erfindungsgemäß zu verwendenden Lösungen sind alkalisch und weisen einen pH-Wert von 11 bis 14 auf.

Die Behandlung der Kunststoffe erfolgt zweckmäßigerweise bei Temperaturen von 10 bis 90° C, vorzugsweise 25° C.

Die Durchführung des erfindungsgemäßen Verfahrens erfolgt durch übliches Tauchen der Kunststoffwerkstücke, wie Folien, Spritzteile, kupferlaminierte extrudierte Platten oder Formteile, in die erfindungsgemäße Vorbehandlungslösung.

Die Behandlungszeit richtet sich nach dem jeweiligen Kunststoff und beträgt in der Regel 3 bis 10 Minuten, vorzugsweise 5 Minuten. Die vorbehandelten Teile werden dann gespült und können dann weiterbearbeitet werden. Von einem derart vorbehandelten Werkstück perlt Wasser nicht mehr ab.

Einen wesentlichen Einfluß für eine gute Haftung auch nach dem Lötdurchgang läßt sich erzielen, wenn die Kunststoffe nach erfolgter Vorbehandlung mittels eines Ätzbades, vorzugsweise mittels eines Bades enthaltend ein saures Oxydationsmittel aufgerauht und dann in üblicher Weise weiterbehandelt werden. Als saure Oxydationsmittel kann außer Chromschwefelsäure und Chromsäure auch Chlorsäure, Wasserstoffperoxid und Peroxidischwefelsäure verwendet werden.

Die Aktivierung und chemische Metallisierung der erfindungsgemäß vorbehandelten Kunststoffwerkstücke erfolgt in an sich bekannter Weise.

Die Aktivierung kann zum Beispiel mittels eines Palladium-Aktivators erfolgen, der in ionogener Form oder in Form kolloidaler Partikel vorliegt. Gegebenenfalls werden die Palladiumionen auf der Substratoberfläche reduziert, zum Beispiel durch Einwirkung von Dimethylaminoboran oder Natriumborhydrid. Kolloidale Palladiumkeime können mittels Borfluorwasserstoffsäure oder Natronlauge von ihrem Schutzkolloid befreit werden.

Die so behandelten Oberflächen werden nun nach üblichen Verfahren chemisch metallisiert, und zwar unter Verwendung stromloser Nickel-, Kobalt-, Silber-, Palladium-, Zinn-, Gold- oder Kupferbäder. Der zum Beispiel chemisch verkupferte oder vernickelte Kunststoffkörper kann zwecks Verbundverstärkung einer Temperung von 80 bis 120° C unterworfen werden, um gegebenenfalls Wasser oder Lösungsmittel zu entfernen, was etwa eine Stunde dauern kann.

Je nach Anforderungsprofil der metallisierten Kunststoffkörper kann die Schichtdicke des Metalls chemisch oder galvanisch verstärkt und nach üblichen Strukturierungsverfahren bearbeitet werden. Der Verbund Metall-Kunststoff zeichnet sich durch seine große Stabilität und Haftfestigkeit der Metallschicht auf der Substratoberfläche aus.

Das erfindungsgemäße Verfahren läßt sich insbesondere zur Herstellung von Leiterplatten in der Elektrotechnik und Elektronik anwenden.

Derart hergestellte Leiterplatten haben den besonderen Vorteil einer geringen Mikrorauhigkeit und hoher Haftfestigkeit, was von großem Vorteil ist.

Die erfindungsgemäß bekannten Kunststoffwerkstücke weisen hohe Haftfestigkeitswerte von bis zu 15 N/cm auf.

Ein besonders überraschender Vorteil der Anmeldung besteht darin, daß der Angriff der im Lösungs- beziehungsweise Quellmittel gelösten Hydroxid-Ionen nicht nur die Haftfestigkeitswerte des Verbundsystems Metall-Kunststoff erhöhen, sondern auch gleichmäßige reproduzierbare Haftfestigkeitswerte ergeben. So wurden keine schlechten Haftfestigkeitswerte, auch bei längeren Arbeitsdurchsätzen, im Verbund Metall-Kunststoff beobachtet, wie es zum Beispiel bei einer reinen Quellmittel-Chromschwefelsäure-Vorbehandlung des Kunststoffes zeitweise zu bemerken war.

Die folgenden Beispiele dienen zur Erläuterung der Erfindung.

## BEISPIEL 1

Eine Polyethersulfonplatte mit 20 % Glasfaseranteil wird in einer Lösung von 100 g/Liter Tetramethylammoniumhydroxid in N,N-Dimethylformamid/iso-Propanol (70 : 30) 30 Sekunden bei Raumtemperatur getaucht, anschließend gespült und dann 12 Minuten in eine handelsübliche 70° C heiße schwefelsaure Chrom-VI-oxid-Beize getaucht. Nach dem Beizangriff wird die Platte 2 Minuten gespült und das noch auf der Substratoberfläche befindliche sechswertige Chrom mittels einer 10%igen wässrigen $NaHSO_3$-Lösung zu Chrom-III reduziert.

Die Substratoberfläche der Platte ist nach der Behandlung schwach aufgerauht und zeigt eine gute Benetzung mit Wasser. Anschließend wird mit einem ionogenen Palladium-II-Komplex aktiviert, mit Natriumborhydrid reduziert und in einem üblichen Dünnkupferbad auf 0,2 $\mu$m Schichtdicke chemisch verkupfert. Nach dem Tempern der chemisch verkupferten Polyethersulfonplatte eine Stunde lang bei 100° C wird in einem handelsüblichen schwefelsauren Kupferelektrolyten ganzflächig auf 35 $\mu$m Schichtdicke verkupfert. Der Kupferüberzug, der abschließend 2 Stunden bei 130° C getempert wurde, weist einen Haftfestigkeitswert im Peel-Test (DIN-Norm 53494) von 14 - 15 N/cm auf.

## BEISPIEL 2

Eine Polyethersulfonplatte mit 10% Glasfaseranteil und 10% Mineralanteil wird analog dem Beispiel 1 in einer Lösung von 80 g/l Tetramethylammoniumhydroxid in N,N-Dimethylformamid/iso-Propanol (70 : 30) 30 Sekunden bei Raumtemperatur getaucht und wie dort beschrieben auf 35 $\mu$m Schichtdicke aufgekupfert.

Der Haftfestigkeitswert nach DIN-Norm 53494 beträgt 12 - 13 N/cm.

## BEISPIEL 3

Eine Polyethersulfonplatte mit 20% Glasfaseranteil wird 1 Minute lang in einer Lösung von N,N-Dimethylformamid/$H_2O$ (90 : 10) bei Raumtemperatur getaucht, gespült und anschließend 15 Minuten in einer handelsüblichen 70° C heißen Chromschwefelsäurebeize getaucht. Die hydrophile, aufgerauhte Oberfläche wird wie im Beispiel 1 beschrieben auf 35 $\mu$m Kupfer verstärkt. Der Haftfestigkeitswert nach DIN-Norm beträgt 10 N/cm. Der Vergleich von Beispiel 3 und 1 macht den Einfluß der Substanz Tetramethylammoniumhydroxid auf die Haftfestigkeit des Verbundes Kupfer-Polyethersulfon deutlich.

## BEISPIEL 4

Eine Polyethersulfonplatte mit 30% Glasfaseranteil wird 30 Sekunden in eine Lösung von 40 g/l Tetramethylammoniumhydroxid in Dimethylsulfoxid/Wasser (90 : 10) getaucht, gespült und anschließend 15 Minuten in einer handelsüblichen 65° C heißen schwefelsauren Chrom-VI-oxid-Beize behandelt. Der weitere Arbeitsablauf bis zum Finish von 35 $\mu$m galvanisch Kupfer ist dem Beispiel 1 zu entnehmen.

Der Haftfestigkeitswert nach DIN-Norm beträgt 9 - 11 N/cm.

## Ansprüche

1. Verfahren zur Vorbehandlung von Kunststoffen, insbesondere von Polyethersulfonen, für die haftfeste chemische Metallisierung, dadurch gekennzeichnet, daß die Kunststoffe mit einer quartären Base gelöst in einem organischen Lösungsmittel behandelt werden.

2. Verfahren gemäß Anspruch 1, dadurch gekennzeichnet, daß als quartäre Base ein quartäres Ammonium-, Phosphonium- oder Arsoniumhydroxid verwendet wird.

3. Verfahren gemäß Ansprüchen 1 und 2, dadurch gekennzeichnet, daß als quartäre Base ein C$_1$-C$_4$-Alkyl-ammoniumhydroxid, Arylammoniumhydroxid, Vinyltriarylphosphoniumhydroxid, Tetraphenylphosphoniumhydroxid oder Tetraphenylarsoniumhydroxid verwendet wird.

4. Verfahren gemäß Ansprüchen 1 bis 3, dadurch gekennzeichnet, daß als quartäre Base Tetramethylammoniumhydroxid verwendet wird.

5. Verfahren gemäß Ansprüchen 1 bis 4, dadurch gekennzeichnet, daß die quartäre Basen aus ihren Salzen in Gegenwart von Hydroxylionen gebildet werden.

6. Verfahren gemäß Anspruch 5, dadurch gekennzeichnet, daß als Salze die Halogenide, Tetrafluoro-(Hydro, Phenyl)-Borate, Perjodate, Hydrosulfate, Dihydrogenphosphate oder Hexafluorophosphate verwendet werden.

7. Verfahren gemäß Anspruch 5, dadurch gekennzeichnet, daß die Hydroxylionen aus Alkalihydroxiden gebildet werden.

8. Verfahren gemäß Anspruch 1, dadurch gekennzeichnet, daß ein organisches Lösungsmittel verwendet wird, welches löslich ist in Wasser, Alkoholen oder Ethern.

9. Verfahren gemäß Anspruch 8, dadurch gekennzeichnet, daß das organische Lösungsmittel gleichzeitig ein Quellmittel für den Kunststoff sein kann.

10. Verfahren gemäß Ansprüchen 8 und 9, dadurch gekennzeichnet, daß als Lösingsmittel und/oder Quellmittel Alkylsulfoxide, Dialkylsulfoxide, Dialkylcarbonate, Dialkylacetamide, N,N-Dialkylformamide, Pyrrolidone, Alkohole und/oder Ether verwendet werden.

11. Verfahren gemäß Ansprüchen 8 bis 10, dadurch gekennzeichnet, daß die Lösungsmittel und/oder Quellmittel in Mischung mit Wasser oder niedrigen Alkoholen verwendet werden.

12. Verfahren gemäß Anspruch 1, dadurch gekennzeichnet, daß die quartäre Base in Konzentrationen von 0,05 bis 200 g/Liter verwendet werden.

13. Verfahren gemäß Anspruch 1, dadurch gekennzeichnet, daß das organische Lösungsmittel in Anwendungskonzentrationnen von 10 bis 100 Gewichtsprozent verwendet wird.

14. Verfahren gemäß Anspruch 1, dadurch gekennzeichnet, daß die Behandlung bei Temperaturen von 10 bis 90° C durchgeführt wird.

15. Verfahren gemäß Anspruch 1, dadurch gekennzeichnet, daß die Kunststoffe nach erfolgter Vorbehandlung mittels eines Ätzbades, vorzugsweise eines Bades enthaltend ein saures Oxydationsmittel, aufgerauht werden.

16. Verfahren gemäß Anspruch 15, gekennzeichnet durch die Verwendung eines schwefelsauren Chrom-VI-oxid enthaltenden Ätzbades.

17. Verfahren gemäß Anspruch 1, dadurch gekennzeichnet, daß die Kunststoffe nach erfolgter Vorbehandlung, gegebenenfalls nach anschließender Aufrauhung in an sich bekannter Weise aktiviert und chemisch metallisiert werden.

18. Verfahren gemäß Anspruch 17, dadurch gekennzeichnet, daß die Aktivierung mittels einer Lösung enthaltend kolloidales oder ionogenes Palladium erfolgt, welches in an sich bekannter Weise von Schutzkolloid befreit oder zum nullwertigen Metall reduziert wird.

19. Verfahren gemäß Anspruch 1, dadurch gekennzeichnet, daß die chemische Metallisierung mittels eines Kupfer-, Silber-, Palladium-, Gold-, Zinn-, Kobalt- und/oder Nickelbades erfolgt.

20. Verfahren gemäß Anspruch 1, daß als Kunststoff auf Basis eines Polyethersulfons ein amorphes aromatisches hochtemperaturbeständiges thermoplastisches Polyethersulfon verwendet wird. Hierunter fallen alle technischen Produkte, die SO$_2$-, Ether- und Phenylengruppen enthalten.

21. Verfahren gemäß Anspruch 1, dadurch gekennzeichnet, daß die Kunststoffe als Folie, als Spritzmittel, als kupferlaminierte extrudierte Platte oder als Formteil vorliegen.

22. Verfahren gemäß Ansprüchen 1 bis 21 zur Herstellung von Leiterplatten.

23. Leiterplatten hergestellt nach Verfahren gemäß Ansprüchen 1 bis 21.